# EUROPÄISCHE PATENTANMELDUNG

(11) **EP 1 207 732 A2**
(43) Veröffentlichungstag der Anmeldung: **22.05.2002**
(21) Anmeldenummer: 01126283.9
(22) Anmeldetag: 06.11.2001
(51) Int. Cl.: H05K 7/20, H02B 1/56

(54) **Schaltschrank mit einer Klimatisierungseinrichtung**

(30) Priorität: 11.11.2000 DE 10055972
(71) Anmelder: Rittal GmbH & Co. KG, 35745 Herborn (DE)
(72) Erfinder: Holighaus, Heiko, 35713 Eschenburg (DE); Nicolai, Walter, 35418 Buseck 1 (DE)
(74) Vertreter: Fleck, Hermann-Josef, Dr.-Ing.

(57) **Zusammenfassung**

Die Erfindung betrifft einen Schaltschrank mit einer Klimatisierungseinrichtung, die einen Wärmetauscher aufweist, wobei dem Wärmetauscher die im Schaltschrank-Innenraum befindliche Luft zuleitbar oder zugeleitet und mittels diesem klimatisierbar ist.

Eine effektive Klimatisierung des Schaltschrank-Innenraumes mit gleichzeitig geringem Energiebedarf wird dann möglich, wenn der Wärmetauscher als Erdwärmetauscher ausgebildet und im Erdreich verlegt ist.

## Beschreibung

Die Erfindung betrifft einen Schaltschrank mit einer Klimatisierungseinrichtung, die einen Wärmetauscher aufweist, wobei dem Wärmetauscher die im Schaltschrank-Innenraum befindliche Luft zuleitbar oder zugeleitet und mittels diesem klimatisierbar ist.

Derartige Schaltschränke sind vielfältig bekannt. Zur Klimatisierung des Schaltschrank-Innenraumes werden separate Klimageräte außenseitig an den Schaltschrank angebaut, wie dies beispielsweise die DE 197 124 74 C1 oder die DE 196 097 94 C1 ausweist. Deckelseitig montierbare Klimageräte sind aus der DE 41 072 29 C2 bekannt.

Die bekannten Klimageräte weisen üblicherweise einen Kältekreislauf auf, damit ausreichend hohe Verlustleistungen aus dem Schaltschrank-Innenraum abgeführt werden können. Derartige Klimageräte haben einen relativ hohen Energieverbrauch. Wenn Schaltschränke im Außenbereich gestellt sind, so sind mangels Stromanschluß häufig Batterien zur Stromversorgung erforderlich, in regelmäßigen Intervallen einer Wartung und ggf. Nachladung unterzogen werden müssen.

Es ist Aufgabe der Erfindung, einen Schaltschrank der eingangs erwähnten Art zu schaffen, bei dem eine leistungsfähige Schaltschrankklimatisierung mit geringen Energieaufwand möglich wird.

Diese Aufgabe wird dadurch gelöst, dass der Wärmetauscher einen Erdwärmetauscher aufweist, der im Erdreich verlegt ist.

Bei dem Erdwärmetauscher macht man sich die Erkenntnis zu Nutze, dass ab einer Tiefe von ca. 1 m im Erdboden ein relativ konstantes Temperaturniveau vorherrscht (6°C bis 11°C). Da das Erdreich, besonders wenn es feucht ist, eine hohe Speicherkapazität besitzt, läßt sich dieser Wärmerespeicher effektiv zur Schaltschrankkühlung nutzen. Beim Sommerbetrieb des Schaltschrankes und zugelassenen Innentemperaturen von beispielsweise 45°C stehen also ca. 34°Kelvin Temperaturdifferenz für den Erdwärmetauscher zur Verfügung. Damit lassen sich ohne Weiteres hohe Kühlleistungen erreichen. Im Winter, wenn sich die Temperaturverhältnisse umkehren, kann bei zugelassenen Innentemperaturen im Schaltschrank-Innenraum von 0°C eine Temperaturdifferenz von beispielsweise 6° Kelvin für den Erdwärmetauscher genutzt werden. Der Erdwärmetauscher arbeitet dann als Heizung.

Durch den Erdwärmetauscher kann die im Schaltschrank-Innenraum gehaltene Luft gefördert werden. Denkbar ist es jedoch auch, beliebige Fluide durch den Erdwärmetauscher zu führen. Dementsprechend können besondere Gase oder Flüssigkeiten transportiert werden. Insbesondere dann, wennbesondere Gase oder Flüssigkeiten verwendet sind, ist dem Schaltschrank-Innenraum ein Innen-Wärmetauscher zugeordnet. Durch diesen zirkuliert dann das vom Erdwärmetauscher kommende Fluid. Dem Wärmetauscher kann dann zur Verbesserung des Wirkungsgrades ein Lüfter zugeordnet sein.

Eine technisch besonders einfach gestaltete Ausführungsvariante ist dergestalt, dass der Erdwärmetauscher an eine Zu- und eine Ableitung angekoppelt ist, wobei dem Erdwärmetauscher über die Zuleitung aus dem Schaltschrank-Innenraum kommende Luft zuleitbar ist und wobei diese im Erdwärmetauscher klimatisierte Luft nach Durchströmen des Erdwärmetauschers über die Ableitung zumindest teilweise wieder in den Schaltschrank-Innenraum zurückführbar ist. Dadurch, dass der Luftvorrat aus dem Schaltschrank direkt durch den Erdwärmetauscher gefördert wid, sind nur wenige Bauteile erforderlich.

Gemäß einer bevorzugten Erfindungsausgestaltung der Erfindung ist es vorgesehen, dass der Erdwärmetauscher als flexibles Kunststoffohr ausgebildet ist. Dieses Kunststoffrohr läßt sich als eine Einheit auf einfache Weise zeitsparend im Erdreich verlegen. Dabei kann es insbsondere vorgesehen sein, dass die Ableitung und die Zuleitung einteilig mit dem Erdwärmetauscher verbunden und bis in den Bereich des Schaltschrank-Innenraums geführt sind oder dass diese Ableitung und die Zuleitung an Rohranschlußstücke angekoppelt sind, die in den Schaltschrank-Innenaum führen. Dadurch, dass die Ab- und die Zuleitung einteilig mit dem Erdwärmetauscher ausgebildet sind, ist kein zusätzlicher Montage- und Teileaufwand erforderlich. Das Kunststoffrohr kann dann bis in den Bereich des Schaltschrank-Innenraums geführt werden oder an entsprechende Rohranschlüsse angekoppelt werden.

Gemäß eine alternativen Ausgestaltungsvariante der Erfindung kann es auch vorgesehen sein, dass der Erdwärmetauscher aus biegesteifen Rohrabschnitten und Rohrkrümmern zusammengesetzt ist. Beispielsweise können als biegesteife Rohrabschnitte und Rohrkrümmer aus der Sanitärtechnik übliche Leitungsstücke verwendet werden. Diese besitzen eine ausreichende Druckstabilität. Des Weiteren kann an der Rohrwandung ein ausreichend hoher Wärmeübergang gewährleistet werden.

Ein effektiver Wärmeabtausch im Schaltschrank-Innenraum wird dann möglich, wenn vorgesehen ist, dass die Ableitung im Dachbereich des Schaltschrank-Innenraumes eine Einblas- oder Einsaugöffnung bildet, und dass die Zuleitung die klimatisierte Luft im Bodenbereich dem Schaltschrank-Innenraum zuführt.

Gemäß einer bevorzugten Ausgestaltungsvariante der Erfindung ist es vorgesehen, dass der Zu- und/oder der Ableitung wenigstens ein Lüfter zugeordnet ist. Die Verwendung eines oder mehrerer Lüfter ermöglicht einen geräuscharmen Klimagerät-Betrieb. Dies wird insbesondere dann möglich, wenn zusätzlich vorgesehen ist, dass der Schaltschrank-Innenraum von einem Schaltschrankkorpus umgeben ist, und dass der oder die Lüfter im Schaltschrank-Innenraum untergebracht ist (sind). Es sind dann keine lärmerzeugenden Teile des Klimagerätes außerhalb des Schaltschrankes vorhanden, wie dies überlicher Weise bei Klimageräten notwendig ist. Die verwendeten Lüfter benötigen nur wenig elektrische Energie. Sie können insbesondere als Gleichstromlüfter ausgebildet sein, die direkt von einer Batterie, die dem Schaltschrank-Innenraum zugeordnet ist, gespeist werden.

Der Erdwärmtauscher wird in bevorzugter Weise mäanderförmig im Erdbereich verlegt. Dabei sind zwischen den einzelnen Schlaufen, die den Mäander bilden, Abstandsräume geschaffen. Die Schlaufen müssen dabei ausreichend weit von einander beabstandet sein, dass keine gegenseitige Wärmebeeinträchtigung stattfinden kann.

Ein erfindungsgemäßer Schaltschrank kann sich dadurch auszeichnen, dass ein Schrankkorpus auf einem Schaltschranksockel befestigt ist, dass der Schrankkorpus den Schaltschrank-Innenraum umschließt. Die Bodengruppe bildet eine Abschottung zwischen dem Unterbau, der den Schaltschrank trägt, beispielsweise einem Betonsockel, und dem eigentlichen Schaltschrankkorpus.

Damit wird verhindert, dass je nach Ausführung der Abdichtung der Bodengruppe Feuchtigkeit in den Schaltschrank-Innenraum gelangt. Für manche Anwendungsfälle kann es auch vorgesehen sein, dass die Abdichtung verhindert, dass beispielsweise Nagetiere in den Schaltschrank-Innenraum gelangen können.

Erfindungsgemäß kann es auch weiterhin vorgesehen sein, dass die Zu- und die Ableitung schaltschrankseitig mittels luftdurchlässiger Abdeckungen verschlossen sind. Dies verhindert, dass beim Montieren im Schaltschrank-Innenraum Gegenstände, beispielsweise Werkzeuge, in den Erdwärmetauscher fallen können. Des Weiteren verhindert dies, dass Nagetiere, die ggf. in den Rohrbereich des Erdwärmetauschers vorgedrungen sind, auch in den Schaltschrank-Innenraum gelangen können.

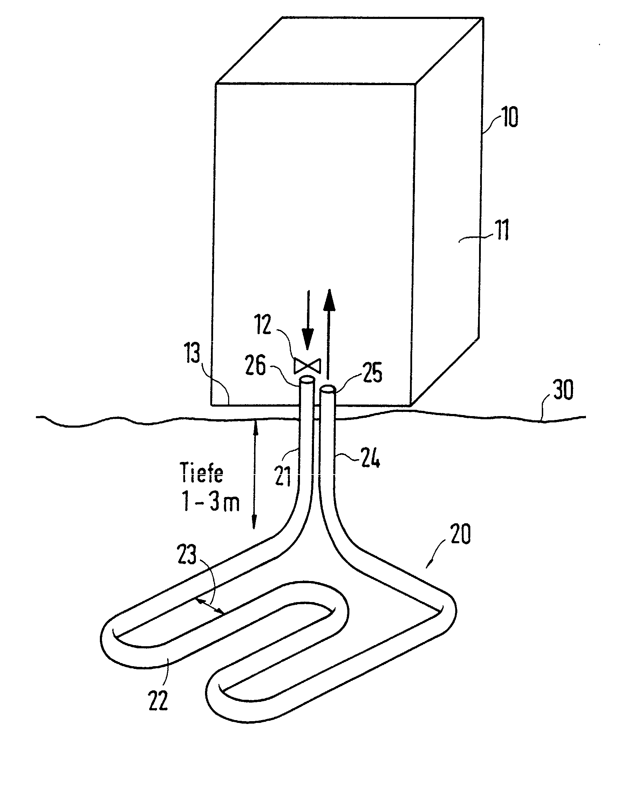

Die Erfindung wird im Folgenden anhand eines in der Zeichnung dargestellten Ausführungsbeispieles näher erläutert. Wie die Zeichnung erkennen läßt, ist oberhalb des Erdniveaus 30 ein Schaltschrank 10 aufgstellt. Der Schaltschrank 10 besitzt einen Schaltschranksockel 13. Dieser ist auf einer im Erdreich einbetonierten Betonplombe fixiert. Aus der Betonplombe ragt die Ableitung 21 und die Zuleitung 22 eines Erdwärmetauschers 20. Die Ableitung 21 bildet die Einsaugöffnung 26; die Zuleitung 24 bildet die Ausblasöffnung 25. Der Einsaugöffnung 26 ist ein Lüfter 12 zugeordnet. Der Lüfter 12 besitzt einen Gleichstrom-Motor, der von einer im Schaltschrank-Innenraum 11 gehaltenen Batterie betrieben wird. Wie die Zeichnung erkennen läßt, ist der Lüfter 12 ebenfalls im Schaltschrank-Innenraum angeordnet. Damit überträgt dieser keine oder nur geringe Geräuschimmissionen an die Umgebung . Der Erdwärmetauscher 20 ist als flexibles Kunststoffrohr ausgebildet, das mäan-derförmig im Erdreich velegt ist. Die Verlegetiefe ist vorliegend im Bereich zwischen einem und drei Metern gewählt. Das Mäander wird von mehreren Schlaufen 22 gebildet, wobei die Schlaufen 22 über Abstandsräume 23 zueinander distanziert angeordnet sind. Die Abstandsräume 23 stellen sicher, dass zwischen den einzelnen Schlaufen keine oder nur geringe Wärme-beeinflussungen stattfinden. Das Kunststoffrohr des Erdwärmetausches umfasst auch die Zu- und die Ableitung 24, 21.

Während des Betriebes des Wärmetauschers wird von dem Lüfter 12 Luft aus dem Schaltschrank-Innenraum angesaugt und über die Ableitung 21 in den Erdwärmetauscher gefördert. Beim Durchtritt durch die einzelnen Schlaufen 22 des Erdwärmetauschers 20 wird die mit dem Luftstrom transportierte Wärmeenergie kontinuierlich an das umgebende Erdreich abgegeben. Die so gekühlte Luft wird dann wieder über die Zuleitung 24 in den Schaltschrank-Innenraum zurückgefördert.

Im Winterbetrieb kehrt sich der Energieeintrag in den Erdwärmetauscher 20 um. Dann wird dem transportierten Luftstrom Wärmeenergie aus dem Erdreich zugeleitet. Diese kann dann in den Schaltschrank-Innenraum abgegeben werden.

## Patentansprüche

1. Schaltschrank mit einer Klimatisierungseinrichtung, die einen Wärmetauscher aufweist, wobei dem Wärmetauscher die im Schaltschrank-Innenraum befindliche Luft zuleitbar oder zugeleitet und mittels diesem klimatisierbar ist,
**dadurch gekennzeichnet,**
**dass** der Wärmetauscher einen im Erdeich verlegten Erdwärmetauscher (20) aufweist.

2. Schaltschrank nach Anspruch 1,
**dadurch gekennzeichnet, dass** der Wärmetauscher einen dem Schaltschrank-Innenraum zugeordneten Innen-Wärmetauscher aufweist, der zusammen mit dem Erdwärmetauscher (20) ein geschlossenes Kreislaufsystem bildet, in dem ein Fluid zirkuliert.

3. Schaltschrank nach Anspruch 1,
**dadurch gekennzeichnet,**
**dass** der Erdwärmetauscher (20) an eine Zu- und eine Ableitung (24 und 21) angekoppelt ist, wobei dem Erdwärmetauscher (20) über die Zuleitung 24) aus dem Schaltschrank-Innenraum kommende Luft zuleitbar ist und wobei diese im Erdwärmetauscher (20) klimatisierte Luft nach Durchströmen des Erdwärmetauschers (20) über die Ableitung (21) zumindest teilweise wieder in den Schaltschrank-Innenraum zurückführbar ist.

4. Schaltschrank nach einem der Ansprüche 1 bis 3,
**dadurch gekennzeichnet,**
**dass** der Erdwärmetauscher (20) als flexibles Kunststoffrohr ausgebildet ist.

5. Schaltschrank nach Anspruch 4,
**dadurch gekennzeichnet,**
**dass** die Ableitung (21) und die Zuleitung (24) einteilig mit dem Erdwärmetauscher (20) verbunden und bis in den Bereich des Schaltschrankinnenraums (11) geführt sind oder
**dass** diese Ableitung (21) und die Zuleitung (22) an Rohranschlußstücke angekoppelt sind, die in den Schaltschrankinnenaum (11) führen.

6. Schaltschrank nach einem der Ansprüche 1 bis 3,
**dadurch gekennzeichnet,**
**dass** der Erdwärmetauscher (20) aus biegesteifen Rohrabschnitten und Rohrkrümmen zusammengesetzt ist.

7. Schaltschrank nach einem der Ansprüche 3 bis 6,
**dadurch gekennzeichnet,**
**dass** die Ableitung (21) im Dachbereich des Schaltschrank-Innenraumes (11) eine Einblas- oder Einsaugöffnung (26) bildet, und
**dass** die Zuleitung (24) die klimatisierte Luft im Bodenbereich dem Schaltschrankinnenraum zugeführt.

8. Schaltschrank nach einem der Ansprüche 3 bis 7,
**dadurch gekennzeichnet,**
**dass** der Zu- und/oder der Ableitung (24, 21) wenigstens ein Lüfter (12) zugeordnet ist.

9. Schaltschrank nach Anspruch 8,
**dadurch gekennzeichnet,**
**dass** der Schaltschrank-Innenraum (11) von einem Schaltschrankkorpus umgeben ist, und
**dass** der oder die Lüfter (12) im Schaltschrank-Innenraum (11) untergebracht ist (sind).

10. Schaltschrank nach einem der Ansprüche 1 bis 9,
daduch **gekennzeichnet**,
dass der Brdwärmetauscher mäanderförmig im Erdbereich verlegt ist.

11. Schaltschrank nach einem der Ansprüche 3 bis 10,
**dadurch gekennzeichnet,**
**dass** ein Schrankkorpus auf einem Schaltschranksockel (13) befestigt ist, dass der Schrankkorpus den Schaltschrank-Innenraum (13) umschließt, und dass der Schaltschranksockel eine Bodengruppe aufweist, an der die Zu- und die Ableitung (24,21) gehalten und abgedichtet in den Schaltschrank-Innenraum (11) geführt sind.

12. Schaltschrank nach einem der Ansprüche 3 bis 11,
daduch **gekennzeichnet**,
dass die Zu- und die Ableitung (24 und 21) schaltschrankseitig mittels luftdurchlässiger Abdeckungen verschlossen sind.
